# DEMANDE DE BREVET EUROPEEN

(11) **EP 1 450 300 A1**
(43) Date de publication de la demande: **25.08.2004**
(21) Numéro de dépôt: 03290437.7
(22) Date de dépôt: 24.02.2003
(51) Int. Cl.: G06K 19/077, G06K 7/00, G09F 3/03, B60J 10/00, H05K 5/00, B65D 53/00, F16B 41/00, H02B 1/06

(54) **Dispositif de scellé à transpondeur multiple**

(71) Demandeur: EUROPEAN COMMUNITY, 1049 Brussels (BE)
(72) Inventeur: Sironi, Marco, 21014 Laveno-Mombello (IT); Tebaldi, Piercarlo, 21020 Brebbia (IT); Korn, Christophe, 21030 Ferrera di Varese (IT); Poucet, André, 21033 Cittiglio (IT)
(74) Mandataire: Freylinger, Ernest T.

(57) **Abrégé**

L'invention concerne un dispositif de scellé (1), comprenant une broche de verrouillage (10) et une douille (20), la broche de verrouillage comprenant une tête (11) et une tige (12) comportant une gorge (13) qui coopère avec un anneau de blocage (24) disposé dans la douille (20) pour verrouiller par insertion ladite douille sur la broche. La douille comprend en outre un premier transpondeur (30) logé dans la partie supérieure de la douille à une profondeur (P) plus grande que la hauteur (H) de la tige (12) et en ce que la broche de verrouillage comprend en outre un second transpondeur (40) disposé sur la périphérie externe de la tige (12). Chaque transpondeur comprend des moyens de stockage pour stocker au moins un code d'identification unique. Ainsi, toute manipulation non autorisée du dispositif de scellé pourra être détectée même en cas de remplacement complet de celui-ci après rupture.

## Description

### Domaine de l'invention

La présente invention concerne un dispositif de scellé pour fermer et marquer des objets. Plus particulièrement, l'invention se rapporte aux dispositifs de scellé qui mettent en oeuvre des moyens électroniques d'identification.

### Art antérieur

De nombreux types de scellés sont actuellement utilisés pour contrôler le cheminement ou le stockage de produits ou matériels qui présentent des besoins de sécurité ou de contrôle plus ou moins importants, comme, par exemple, des marchandises de fret quelconques, des matières nucléaires, certains types de déchets ou bien de l'argent.

Les technologies employées pour la réalisation des scellés sont très variées et dépendent principalement de l'usage et des degrés de sécurité demandés.

Ainsi, lorsqu'on désire s'assurer simplement de l'intégrité d'un objet, tel qu'un sac ou un container, la fonction du scellé est de garantir que l'objet n'a pas été ouvert sans autorisation. Dans ce cas, des dispositifs peu onéreux, comme de simples colliers de plastique ou de métal apposés sur les organes d'ouverture de l'objet, peuvent être utilisés. Une inspection visuelle de l'intégrité de la structure des colliers suffit alors pour constater que le scellé a été violé ou non.

D'autre part, il existe de plus en plus de domaines, comme le transport international, dans lesquels les scellés doivent non seulement remplir leur fonction de base, qui est de pouvoir attester de l'inviolabilité de l'objet, mais aussi pouvoir fournir des informations pendant et après leur transport. Ainsi, il existe actuellement des dispositifs qui comprennent des moyens mécaniques de scellement auxquels sont associés des moyens électroniques ou optiques qui permettent de mémoriser et transmettre des informations.

Cependant, les dispositifs de scellé actuels qui comprennent des moyens électroniques sont complexes et coûteux. Ils sont en général conçus pour un usage spécifique et ne peuvent pas être mis en oeuvre avec n'importe quel type d'objet. De plus, ils présentent une structure mécanique fragile qui les rend très sensibles aux manipulations et aux transports ce qui restreint encore leur utilisation.

### Objet et description succincte de l'invention

La présente invention vise à remédier aux inconvénients précités et à réaliser un dispositif de scellé à usage multiple de faible coût qui est mécaniquement robuste et qui contient des informations consultables de façon simple et rapide. Le dispositif doit aussi permettre un contrôle sûr et aisé de l'intégrité du scellé.

Ces buts sont atteints grâce à un dispositif de scellé, comprenant une broche de verrouillage et une douille, la broche de verrouillage comprenant une tête et une tige comportant une gorge qui coopère avec un anneau de blocage disposé dans la douille pour verrouiller par insertion ladite douille sur la broche, caractérisé en ce que la douille comprend en outre un premier transpondeur logé dans la partie supérieure de la douille à une profondeur plus grande que la hauteur de la tige et en ce que la broche de verrouillage comprend en outre un second transpondeur disposé sur la périphérie externe de la tige, chaque transpondeur comprenant un substrat sur lequel sont formés un circuit électronique et une antenne, ledit circuit électronique comprenant des moyens de stockage pour stocker au moins un code d'identification unique.

Ainsi, grâce au dispositif de scellé selon l'invention, il est possible de marquer tout objet avec une identité unique, ce qui permet de contrôler et de suivre l'objet pendant et après son transport. De plus, le contrôle de l'intégrité du dispositif de scellé s'effectue par interrogation d'un second transpondeur, ce qui ne nécessite aucun démontage du scellé et permet de contrôler en tout lieu la conformité des informations d'identité contenues dans le transpondeur.

Selon un aspect particulier de l'invention, la douille comprend en outre un troisième transpondeur maintenu à l'intérieur de celle-ci à une profondeur inférieure à la hauteur de la tige, le transpondeur comprenant un substrat sur lequel sont formés un circuit électronique et une antenne, ledit circuit électronique comprenant des moyens de stockage pour stocker au moins un code d'identification unique.

Grâce à ce troisième transpondeur placé à une profondeur intermédiaire dans la douille, il est possible de vérifier que le dispositif a été correctement installé, c'est à dire que la douille a été correctement verrouillée sur la broche rendant toute ouverture de l'objet impossible sans destruction du dispositif de scellé.

Pour garantir une complète destruction du troisième transpondeur lors de l'installation du dispositif de scellé, il est maintenu dans la douille par un élément annulaire qui couvre au moins une partie de l'antenne dudit transpondeur. Ainsi, lors d'une interrogation, l'absence de réponse du troisième transpondeur témoigne d'une installation correcte.

Le premier transpondeur peut contenir, en outre d'un code d'identification unique, des données relatives à la date et au lieu de mise en place du dispositif de scellé, ou bien des informations sur des inspections réalisées sur l'objet lors de son transport. Les moyens de stockage du premier transpondeur peuvent comprendre des moyens de cryptage des données.

L'invention a également pour objet un système de contrôle et de suivi d'un objet, ledit objet comprenant au moins un dispositif de scellé comme décrit précédemment, caractérisé en ce qu'il comprend un dispositif de transmission de signaux pour lire ou écrire des informations dans les transpondeurs du dispositif de scellé, des moyens de traitement et des moyens de stockage de données pour enregistrer les informations stockées dans les transpondeurs.

Ainsi, grâce au système de l'invention, l'installation et l'intégrité du dispositif de scellé peuvent être contrôlées par interrogation à distance des transpondeurs sans aucune manipulation du dispositif. De plus, les informations stockées dans le premier transpondeur, à l'exception du code d'identification, peuvent être consultées et mises à jour en temps réel. Les moyens de stockage de données du système permettent en outre de mémoriser des informations importantes, comme le code d'identification, pour permettre par la suite une comparaison avec les codes lus sur le dispositif afin de détecter toute manipulation non autorisée du dispositif.

Selon une caractéristique particulière, les moyens de stockage de données sont accessibles à distance via une liaison réseau. Ceci permet d'effectuer des contrôles en tout lieu et à tout moment en ayant une référence accessible à distance sur les données d'origines associées au dispositif de scellé. Par exemple, on peut lire un code d'un transpondeur lors d'une étape du transport de l'objet marqué avec le dispositif de scellé et comparer le code lu avec celui enregistré à l'origine pour détecter un remplacement non autorisé du dispositif de scellé.

A cet effet, les moyens de traitement peuvent comprendre des moyens logiciels pour confirmer l'installation du dispositif de scellé par interrogation du troisième transpondeur et/ou pour détecter une manipulation non autorisée du dispositif de scellé par interrogation du deuxième transpondeur. Les moyens de traitement peuvent comprendre aussi un moyen logiciel pour détecter un remplacement non autorisé du dispositif de scellé par lecture des codes des transpondeurs du dispositif de scellé et par comparaison desdits codes avec les codes d'origine enregistrés préalablement dans les moyens de stockage de données.

### Brève description des dessins

D'autres caractéristiques et avantages de l'invention ressortiront de la description suivante de modes particuliers de réalisation de l'invention, donnés à titre d'exemples non limitatifs, en référence aux dessins annexés, sur lesquels :
- la figure 1 est une vue en perspective d'un dispositif de scellé conformément à un mode de réalisation selon l'invention,
- la figure 2 est une vue schématique d'un dispositif de scellé en position verrouillée et d'un système d'interrogation et de traitement de l'invention,
- la figure 3 est une vue schématique du type de transpondeur utilisé dans le dispositif de scellé de l'invention,
- la figure 4 est une vue schématique en coupe montrant le dispositif de scellé lors de l'ouverture d'un objet marqué avec le dispositif,
- les figures 5A et 5B montrent des étapes d'installation du dispositif de scellé selon l'invention,
- la figure 6 est une vue en perspective d'un exemple d'application de l'invention.

### Description détaillée des modes de réalisation de l'invention

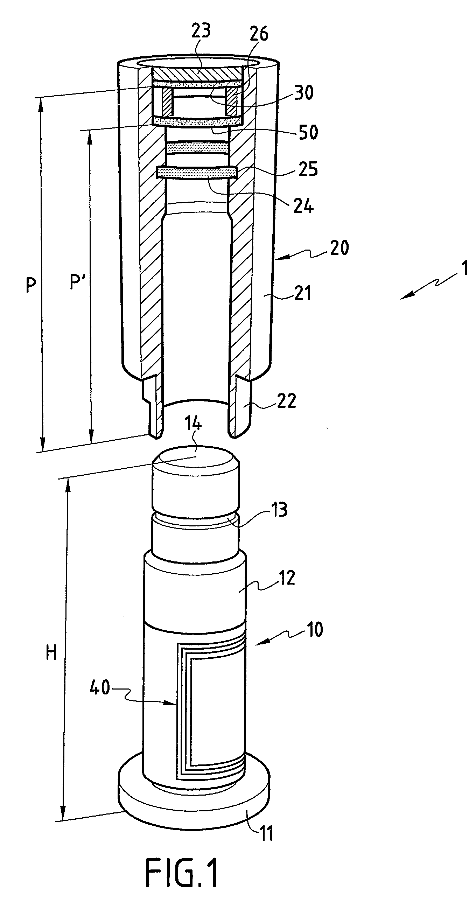

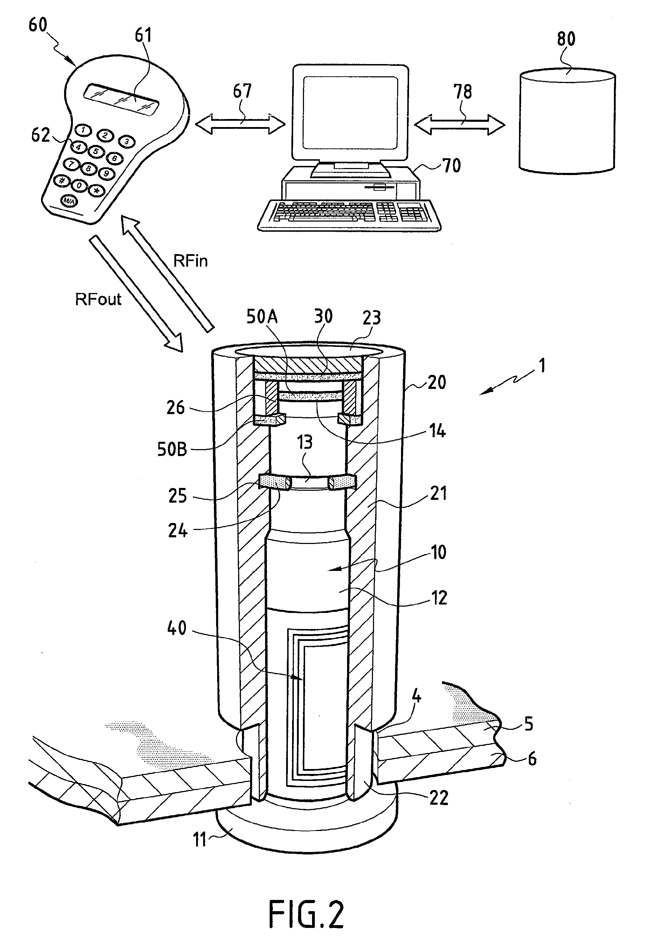

La figure 1 montre le dispositif de scellé 1 selon l'invention. Le dispositif 1 est formé d'une broche de verrouillage 10 et d'une douille 20 destinée à être verrouillée sur la broche 10. La broche 10 et la douille 20 forment un système mécanique auto-bloquant à usage unique qui est utilisé pour marquer la fermeture de tout objet. A cet effet, la broche 10 comprend une tête 11 et une tige 12, la tige 12 comportant une gorge de verrouillage 13 qui coopère avec un anneau de blocage 24 maintenu à l'intérieur de la douille 20 au moyen d'une gorge 25 qui est ménagée dans le corps 21 de la douille. Ainsi, comme illustré sur la figure 2, lorsque la tige 12 de la broche 10 est insérée dans la douille 20, cette dernière est verrouillée sur la tige au moyen de la partie de l'anneau 24 dépassant de la gorge 25 qui s'engage alors dans la gorge 13 pour retenir la douille sur la tige.

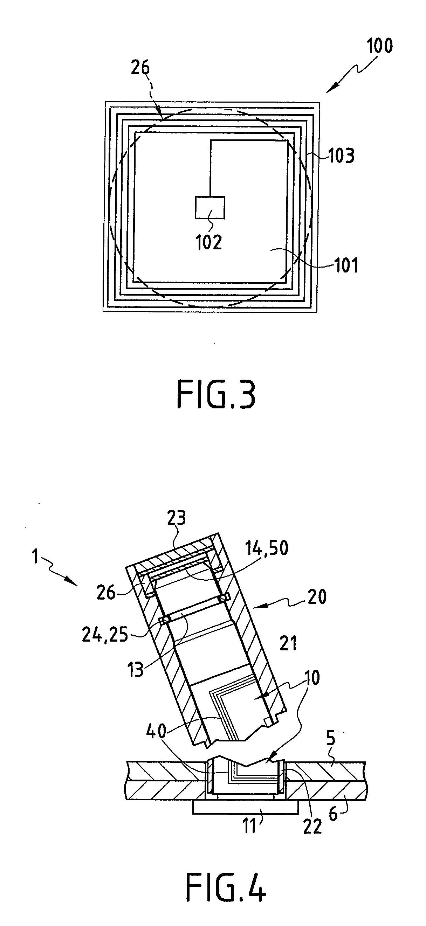

Par exemple, comme illustré sur la figure 2, le dispositif 1 peut être utilisé pour marquer la fermeture d'un objet par la mise en place au niveau de deux éléments 5 et 6 du système de fermeture de l'objet dans lesquels un trou 4 est ménagé. La broche 10 est insérée dans le trou 4 et retenue par la tête 11 qui présente des dimensions supérieures à celles du trou 4. Ensuite, on met en place la douille 20 sur la tige 12 de la broche, ce qui permet de verrouiller les éléments 5 et 6 ensembles. Afin de faciliter l'installation du dispositif, le corps 21 de la douille 20 peut comporter une partie 22 ajustée aux dimensions du trou 4. Par conséquent, une fois le dispositif de scellé 1 installé, l'objet ne pourra être ouvert sans couper ou casser le dispositif 1 (figure 4).

Le dispositif de scellé selon l'invention comprend plusieurs composants électroniques de type transpondeur. Un premier transpondeur 30 est utilisé comme moyen permanent de stockage d'informations relatives au dispositif de scellé et à l'objet auquel il est associé. La nature de ces informations ainsi que leur utilisation seront décrites plus loin en détail. Puisque le transpondeur 30 est un transpondeur permanent, il est disposé dans une partie du dispositif où il sera protégé de toute détérioration. Par exemple, comme illustré sur la figure 1, le transpondeur 30 est logé dans la partie supérieure de la douille 20 à une profondeur P qui est supérieure à la hauteur H de la tige 12 qui correspond à la distance de pénétration maximum de la tige dans la douille. Le transpondeur 30 est maintenu contre un capot 23 qui ferme la partie supérieure du corps 21 de la douille 20. Le transpondeur 30 peut être collé sur le capot 23.

Un deuxième transpondeur 40 est disposé sur la périphérie de la tige 12 de la broche 10. Le transpondeur 40 peut être collé sur la tige 12 pour le maintenir en place sur cette dernière.

Enfin, un troisième transpondeur 50 est maintenu à l'intérieur de la douille 20 à une profondeur intermédiaire P', inférieure à la hauteur H de la tige, par un serre-flanc 26 disposé entre le transpondeur 50 et le transpondeur 30.

La figure 3 illustre la structure générale des transpondeurs 30, 40 et 50 qui sont utilisés dans la présente invention. Tel que représenté en figure 3, un transpondeur 100 est formé d'un substrat 101 sur lequel sont disposées une puce électronique 102 et une antenne 103. L'antenne 103 est formée par un bobinage qui s'étend sur tout le pourtour du substrat. Une extrémité de ce bobinage est reliée à la puce 102. La puce 102 comprend principalement un circuit électronique de mémorisation de données qui peut être accédé en lecture ainsi qu'en écriture le cas échéant. Chaque transpondeur contient à l'origine un code unique permanent qui constitue l'identité du transpondeur et qui ne peut être modifié.

La lecture, et éventuellement l'écriture, de données dans le circuit de mémoire s'effectue par transmission radiofréquence grâce à l'antenne 103 notamment. Si l'on interrompt le bobinage qui constitue l'antenne 103, celle-ci devient inopérante et aucune transmission entre la puce 102 et l'extérieur ne peut plus être réalisée, témoignant ainsi de l'endommagement du composant 100.

Le modèle de transpondeur décrit est de type passif, c'est à dire que l'antenne sert non seulement à la transmission des données mais aussi à recevoir un champ d'activation pour l'alimentation en énergie électrique du circuit électronique de la puce. Il est également possible d'utiliser des transpondeurs qui comprennent un moyen d'alimentation autonome, telle qu'une batterie, celle-ci étant reliée à la puce 102 pour l'alimenter en énergie.

Le type de transpondeur décrit ci-dessus est particulièrement adapté pour la présente invention. En effet, de tels composants présentent un encombrement très réduit ce qui permet de les loger facilement dans des dispositifs de scellé comme celui de l'invention. De plus, le substrat du composant étant en une matière fragile telle que du silicium, il peut être brisé facilement et permettre ainsi la destruction du composant ou au moins de l'antenne de ce dernier avec peu de résistance. Toutefois, suivant sa fonction dans le dispositif de l'invention, la forme, les dimensions et le matériau du substrat pourront être adaptés comme décrit ci-après. Par exemple, pour le substrat du transpondeur 40 qui est destiné à être placé sur la périphérie de la tige 12, on choisit de préférence un matériau souple qui facilite la mise en place du transpondeur sur la tige. De plus, le transpondeur représenté en figure 3 présente la forme d'un carré. Toutefois, en ce qui concerne les transpondeurs 30 et 50 notamment, ceux-ci pourraient avoir aussi une forme circulaire pour faciliter leur intégration dans la douille.

On décrit maintenant plus en détail, les différentes fonctions des transpondeurs qui sont utilisés dans le dispositif de scellé de l'invention.

Le transpondeur permanent 30 est utilisé pour stocker toutes les informations pertinentes qui vont permettre d'identifier l'objet dont la fermeture a été marquée avec le dispositif de scellé de l'invention. A titre d'exemple, l'objet en question peut être un container destiné à transporter une marchandise. Dans ce cas, les informations enregistrées dans le transpondeur 30 peuvent correspondre à la date et au lieu de chargement et de fermeture du container, à la nature de la marchandise transportée, aux diverses inspections douanières effectuées, aux noms ou à l'identification des parties chargées de ces inspections, ....

Le transpondeur 40 qui est disposé sur la tige 12 de la broche 10 est utilisé comme témoin de l'intégrité du dispositif de scellé. En effet, comme illustré sur la figure 4, toute tentative d'ouverture de l'objet scellé, entraîne la rupture du dispositif de scellé 1 et celle du transpondeur 40 qui ne peut plus, par conséquent, être interrogé. Pour tenter de dissimuler une ouverture non autorisée, deux solutions peuvent être envisagées. La première consiste à réparer la tige coupée et à la repositionner dans le dispositif de scellé. La seconde solution consiste à remplacer entièrement le dispositif de scellé par un nouveau. Dans les deux cas, la manipulation non autorisée peut être détectée. En effet, dans le premier cas, en outre des traces sur la douille qui peuvent témoigner d'une telle manipulation, la manipulation frauduleuse sera détectée dès la prochaine interrogation qui révèlera que le transpondeur 40 ne répond pas et que, par conséquent, le dispositif de scellé a été violé. Dans le second cas, où le dispositif a été entièrement remplacé, la lecture révèlera que le code d'identification du transpondeur a changé et qu'il ne correspond pas à celui enregistré au départ.

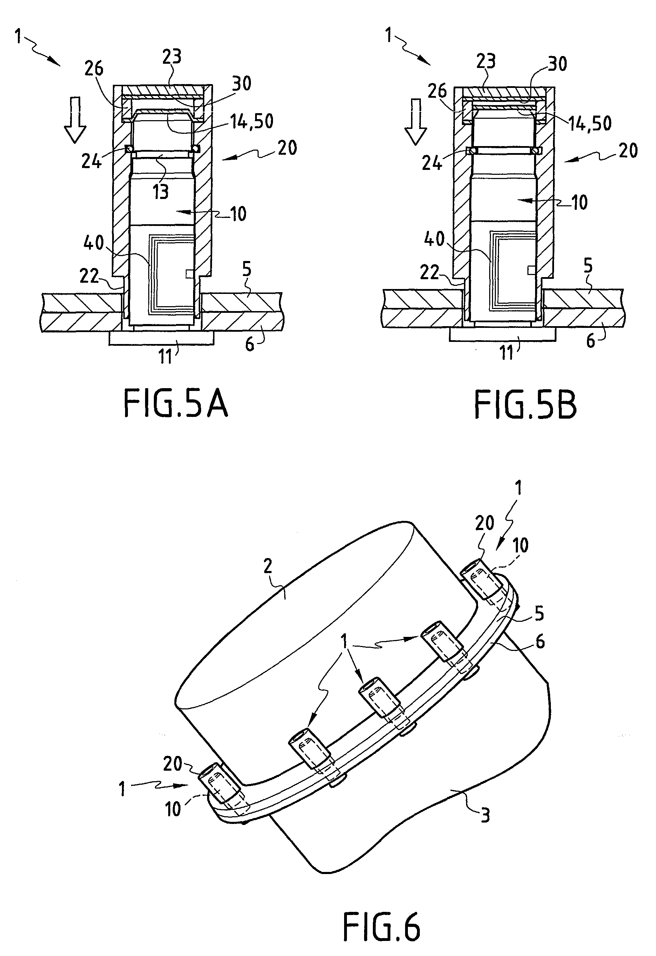

On explique maintenant le rôle du troisième transpondeur 50 du dispositif de scellé de l'invention. Le transpondeur 50 est utilisé comme témoin de la bonne mise en place du dispositif de scellé. En effet, comme illustré sur la figure 1, le transpondeur 50 est maintenu à l'intérieur de la douille 20 à une profondeur P' qui est inférieure à la hauteur H de la tige 12 de la broche 10 correspondant à la distance de pénétration de la tige dans la douille. Par conséquent, tel qu'illustrée sur la figure 5A, lors de la mise en place de la douille 20 sur la broche 10, l'extrémité 14 de la tige 12 va venir buter sur le transpondeur 50. En conséquence, pour amener la douille jusqu'à sa position finale, c'est à dire dans la position où l'anneau 24 est bloqué dans la gorge 13 de la tige, il faudra briser le transpondeur 50. Plus précisément, en référence aux figures 2 et 5B, lorsque le dispositif de scellé a été correctement installé, le transpondeur 50 se trouve en deux morceaux 50A et 50B. Le morceau 50A correspond à la partie du transpondeur qui a été détachée par la tige 12 tandis que le morceau 50B correspond à la partie qui est retenue entre le corps de la douille 21 et le serre-flanc 26. Il faut s'assurer que le serre-flanc 26 qui retient le morceau 50A du transpondeur 50 couvre au moins une partie suffisante du transpondeur pour garantir la destruction du transpondeur. Comme représenté sur la figure 3, le serre-flanc 26 couvre au moins une partie de l'antenne 103 pour assurer la rupture de cette dernière lors de l'installation du dispositif.

Aussi, tant que le transpondeur 50 répond à une interrogation à distance, cela signifie qu'il est intact et que la douille n'est pas correctement positionnée sur la broche.

La lecture et/ou l'enregistrement de données dans les transpondeurs, peut être effectuée par exemple à l'aide d'un dispositif de transmission radiofréquence 60 représenté en figure 2. La transmission entre le dispositif 60 et les transpondeurs s'effectue par des signaux radiofréquences RFin et RFout qui correspondent respectivement aux signaux reçus et aux signaux envoyés par le dispositif 60. Ainsi, avec le dispositif 60, il est possible de lire et/ou d'écrire dans la mémoire des transpondeurs.

A titre d'exemple, le dispositif 60 peut être un lecteur portable qui permet de lire et d'écrire des données dans un transpondeur. Un tel lecteur comporte un écran d'affichage 61, un clavier 62 et/ou des moyens de mémorisation des données interrogées. Le lecteur active le transpondeur par radiofréquence (RF), par exemple à une fréquence de 13.56 MHz. Cette onde charge une capacité présente dans le circuit du transpondeur. Lorsque cette dernière se décharge, elle renvoie au lecteur un code ou une information, inscrite dans la mémoire du transpondeur. Ce type de lecteur portable permet d'échanger des données avec les transpondeurs sur une distance de 30 cm environ. Alternativement, il est possible d'utiliser divers types de lecteurs non portables qui présentent des géométries d'antennes permettant une lecture/écriture en série à une distance plus grande.

Le code et/ou les informations de chaque transpondeur interrogé sont ainsi envoyés vers le dispositif 60. Dans le cas d'un lecteur portable, ces données peuvent être affichées sur son écran 61 et/ou stockées dans sa mémoire. Le dispositif 60 peut également comprendre des moyens de traitement intégrés spécialement programmés pour effectuer les contrôles décrits ici.

Alternativement, des moyens de traitement, tel qu'un ordinateur 70, peuvent être utilisés pour traiter les données des transpondeurs. Dans ce cas, comme illustré sur la figure 2, l'ordinateur est relié au dispositif 60, via une liaison série 67, pour pouvoir échanger des données avec chaque mémoire de transpondeur. Dans tous les cas, les moyens de traitement comprennent et exécutent des logiciels qui permettent de réaliser toutes sortes de fonctions de contrôle et de suivi à partir des données des transpondeurs.

Par exemple, selon le cas, le dispositif 60 ou l'ordinateur 70 peut comprendre des moyens logiciel pour contrôler au départ l'installation du dispositif par interrogation du transpondeur 50. L'information de rupture du transpondeur 50, qui témoigne donc de la pose correcte du dispositif de scellé, peut être utilisée comme information de départ par les moyens de traitement pour, par exemple, mémoriser les codes d'identification d'un ou plusieurs transpondeurs en vu de contrôles futurs. Le logiciel peut également permettre d'établir la corrélation entre le numéro d'identification d'un des transpondeurs et des données diverses telles que le lieu, et/ou le nom de l'inspecteur ayant installé le dispositif de scellé, et/ou la date de pose de celui-ci. Le logiciel peut également être utilisé pour écrire ou mettre à jour des données dans les transpondeurs (à l'exception du code d'identification qui ne peut être modifié).

Des informations, comme les codes d'identification, peuvent être stockées sur une base de données 80 (figure 2) qui peut être accédée en ligne, par une liaison réseau 78 telle qu'une liaison Internet par exemple. Le dispositif de transmission 60, l'ordinateur 70 et la base de données 80 constituent un système qui permet de contrôler et de suivre en temps réel tout objet qui est marqué par un ou plusieurs dispositifs de scellé de l'invention. Ceci permet un suivi et un contrôle de la marchandise tout au long de son transport. L'intégrité du dispositif peut être contrôlée à tout moment. En effet, l'interrogation du transpondeur 40 permet de déterminer dans un premier temps si ce dernier est intact et, le cas échéant, de comparer le code lu dans ce dernier avec le code enregistré à l'origine dans la base de donnée 80 qui peut être accédée à distance via la liaison réseau 78.

Enfin, le transpondeur permanent 30 qui peut contenir toutes sortes d'informations enrichies au cours des étapes du transport de l'objet, constitue ainsi l'historique du dispositif de scellé qui peut être consulté en temps réel par interrogation du transpondeur 30 sur un lieu de contrôle.

Selon le principe du scellé, celui-ci ne peut être apposé qu'une fois sans atteinte à son intégrité. Le dispositif de scellé selon l'invention répond aux mêmes exigences. Ses applications peuvent être multiples. Comme représentés sur la figure 6, une pluralité de dispositifs 1 sont utilisés pour marquer la fermeture d'un couvercle 2 sur une enceinte 3. Dans ce cas, les éléments 5 et 6 correspondent à des collerettes dans lesquelles des orifices de passage des dispositifs 1 sont ménagés. L'intégrité du système ainsi formé est garantie et peut être contrôlée facilement comme décrit plus haut.

Le scellé selon l'invention présente les avantages suivants.

Il permet une identification sûre pour chaque objet sur lequel il est apposé.

L'installation du dispositif de scellé peut être validée par interrogation d'un transpondeur.

L'objet scellé et sa marchandise peuvent être suivis tout au long du transport par interrogation des transpondeurs et transmission des informations. En effet, les informations, telles que des codes d'identification, peuvent être lues autant de fois que nécessaire puisque cela se fait sans démontage ou altération du dispositif scellé et, par conséquent, sans atteinte à son intégrité.

L'intégrité du dispositif peut être contrôlée en tout lieu, soit directement lorsque le transpondeur ne répond plus, soit par comparaison avec le ou les codes d'identification lus sur site et comparés avec ceux enregistrés à l'origine dans une base de données accessible en ligne lorsque le dispositif a été remplacé sans autorisation. On peut alors, par analyse des données enregistrées dans le transpondeur permanent, déterminer éventuellement le responsable, le lieu et la date de la manipulation non autorisée.

Lorsque le circuit du transpondeur comprend des moyens programmables ou encryptables, il est possible de coder ou crypter les données mémorisées dans le scellé, d'où un niveau de sécurité accru.

Le dispositif de scellé présente un faible coût de fabrication.

Le dispositif de scellé présente une bonne robustesse mécanique qui permet de l'utiliser avec des objets de transport comme des containers qui sont souvent manipulés sans précaution particulière.

## Revendications

1. Dispositif de scellé (1), comprenant une broche de verrouillage (10) et une douille (20), la broche de verrouillage comprenant une tête (11) et une tige (12) comportant une gorge (13) qui coopère avec un anneau de blocage (24) disposé dans la douille (20) pour verrouiller par insertion ladite douille sur la broche, **caractérisé en ce que** la douille comprend en outre un premier transpondeur (30) logé dans la partie supérieure de la douille à une profondeur (P) plus grande que la hauteur (H) de la tige (12) et **en ce que** la broche de verrouillage comprend en outre un second transpondeur (40) disposé sur la périphérie externe de la tige (12), chaque transpondeur comprenant un substrat (101) sur lequel sont formés un circuit électronique (102) et une antenne (103), ledit circuit électronique comprenant des moyens de stockage pour stocker au moins un code d'identification unique.

2. Dispositif selon la revendication 1, **caractérisé en ce que** la douille (20) comprend en outre un troisième transpondeur (50) maintenu à l'intérieur de celle-ci à une profondeur (P') inférieure à la hauteur (H) de la tige, le transpondeur comprenant un substrat (101) sur lequel sont formés un circuit électronique (102) et une antenne (103), ledit circuit électronique comprenant des moyens de stockage pour stocker au moins un code d'identification unique.

3. Dispositif selon la revendication 2, **caractérisé en ce que** le troisième transpondeur (50) est maintenu dans la douille (20) par un élément annulaire (26) qui couvre au moins une partie de l'antenne (103) dudit transpondeur.

4. Dispositif selon l'une quelconque des revendications 1 à 3, **caractérisé en ce que** les moyens de stockage du premier transpondeur (30) contiennent des données relatives à la date et au lieu de mise en place du dispositif de scellé.

5. Dispositif selon l'une quelconque des revendications 1 à 4, **caractérisé en ce que** les moyens de stockage du premier transpondeur comprend des moyens de cryptage des données.

6. Système de contrôle et de suivi d'un objet, ledit objet comprenant au moins un dispositif de scellé selon l'une quelconque des revendications 1 à 5, **caractérisé en ce qu'**il comprend un dispositif de transmission de signaux (60) pour lire ou écrire des informations dans les transpondeurs du dispositif de scellé, des moyens de traitement (70) et des moyens de stockage de données (80) pour enregistrer les informations stockées dans les transpondeurs.

7. Système selon la revendication 6, **caractérisée en ce que** les moyens de stockage de données (80) sont accessibles à distance via une liaison de réseau (78).

8. Système selon la revendication 6 ou 7, **caractérisé en ce que** les moyens de traitement comprennent un moyen logiciel pour confirmer l'installation du dispositif de scellé (1) par interrogation du troisième transpondeur (50).

9. Système selon l'une quelconque des revendications 6 à 8, **caractérisé en ce que** les moyens de traitement comprennent un moyen logiciel pour détecter une manipulation non autorisée du dispositif de scellé par interrogation du deuxième transpondeur (40).

10. Système selon l'une quelconque des revendications 6 à 9, **caractérisé en ce que** les moyens de traitement comprennent un moyen logiciel pour détecter un remplacement non autorisé du dispositif de scellé par lecture des codes des transpondeurs du dispositif de scellé (1) et par comparaison desdits codes avec les codes enregistrés préalablement dans les moyens de stockage de données (80).
